# FASCICULE DE BREVET EUROPEEN

(11) **EP 2 870 272 B1**
(45) Date de publication et mention de la délivrance du brevet: **22.06.2016**
(21) Numéro de dépôt: 13744678.7
(22) Date de dépôt: 03.07.2013
(51) Int. Cl.: C23C 16/04, C23C 16/46, C04B 35/00, C23C 16/455, C23C 16/458

(54) **DISPOSITIF DE CHARGEMENT ET INSTALLATION POUR LA DENSIFICATION DE PRÉFORMES POREUSES TRONCONIQUES EMPILABLES.**
LADEVORRICHTUNG UND ANLAGE ZUR VERDICHTUNG STAPELBARER PORÖSER VORFORMEN IN KEGELSTUMPFFORM
CHARGING DEVICE AND INSTALLATION FOR DENSIFYING STACKABLE FRUSTOCONICAL POROUS PREFORMS

(30) Priorité: 04.07.2012 FR 1256407
(43) Date de publication de la demande: 13.05.2015
(73) Titulaire: HERAKLES, 33185 Le Haillan (FR)
(72) Inventeur: GOUJARD, Stéphane, 33700 Merignac (FR); BERTRAND, Sébastien, 33480 Moulis En Medoc (FR); DELCAMP, Adrien, 33700 Merignac (FR); BEAUVAIS, Franck, 33160 Saint Medard En Jalles (FR)
(74) Mandataire: Desormiere, Pierre-Louis
(86) Numéro de dépôt international: PCT/FR2013/051562
(87) Numéro de publication internationale: WO 2014/006324

(56) Documents cités:
- WO-A1-2006/077353
- US-A- 5 904 957
- US-B2- 7 182 980

## Description

### Arrière-plan de l'invention

La présente invention concerne les techniques d'infiltration chimique en phase vapeur utilisées notamment lors de la réalisation de pièces en matériau composite thermostructural. Elle concerne plus particulièrement la densification par dépôt de matrice de préformes poreuses de forme tronconique telles que des préformes fibreuses destinées à la fabrication de divergents de moteurs-fusées ou de pièces d'arrière-corps de moteurs aéronautiques.

Pour la fabrication de pièces en matériau composite, en particulier de pièces en matériau composite thermostructural constituées d'une préforme fibreuse réfractaire (fibres carbone ou céramique, par exemple) densifiée par une matrice réfractaire (carbone et/ou céramique, par exemple), il est courant de faire appel à des procédés d'infiltration chimique en phase vapeur. Des exemples de telles pièces sont des tuyères de propulseurs en composite carbone-carbone (C-C), des disques de freins, notamment de freins d'avions, en composites C-C, ou des aubes en composites à matrice céramique (CMC).

La densification de préformes poreuses par infiltration chimique en phase vapeur consiste à placer les substrats dans une chambre de réaction d'une installation d'infiltration au moyen d'un outillage de support et à admettre dans la chambre un gaz réactif dont un ou plusieurs constituants sont des précurseurs du matériau à déposer au sein des préformes afin d'assurer leur densification. Les conditions d'infiltration, notamment composition et débit du gaz réactif, et température et pression dans la chambre sont choisies pour permettre une diffusion du gaz au sein de la porosité interne accessible des préformes afin qu'y soit déposé le matériau désiré par décomposition d'un constituant du gaz ou réaction entre plusieurs constituants de celui-ci. Le préchauffage du gaz réactif est habituellement réalisé par passage du gaz à travers une zone de préchauffage située dans la chambre de réaction et dans laquelle s'ouvre l'entrée du gaz réactif. Ce procédé correspond au procédé d'infiltration chimique en phase vapeur à flux libre.

Dans une installation industrielle d'infiltration chimique en phase vapeur, il est habituel de charger la chambre de réaction avec plusieurs préformes à densifier simultanément pour augmenter le rendement du procédé de densification et, par conséquent, le taux de chargement des chambres de réaction.

Des procédés et installations de densification de substrats annulaires poreux par infiltration chimique en phase vapeur sont notamment décrits dans les documents US 7 182 980 et US 5 904 957. Cependant, ces procédés s'appliquent essentiellement à la densification de substrats de forme annulaire disposés en piles et ne sont pas adaptés, en termes d'optimisation de chargement, à la densification de préformes de forme tronconique de grandes dimensions. En effet, comme décrits dans les documents US 7 182 980 et US 5 904 957, il est nécessaire de laisser un espace important entre chaque préforme tronconique dans la chambre de réaction afin que les gaz d'infiltration puissent alimenter de manière satisfaisante chaque partie des préformes à densifier, ce qui réduit significativement la capacité de chargement de chaque installation d'infiltration et augmente le coût de fabrication des pièces. Une production à l'échelle industrielle de pièces de forme tronconique et de grandes dimensions nécessite dans ce cas de fabriquer et d'utiliser un nombre important d'installations d'infiltration, ce qui est très pénalisant sur le plan économique.

### Objet et résumé de l'invention

L'invention a, par conséquent, pour but de fournir une solution de chargement qui permet de densifier des préformes poreuses de forme tronconique, en particulier de grandes dimensions et de faible épaisseur, avec une capacité de chargement élevée, et ce en minimisant les gradients de densification dans les substrats.

Ce but est atteint avec un dispositif de chargement comprenant :
- un plateau support,
- un premier empilement d'une pluralité de couronnes inférieures disposé sur le plateau support, chaque couronne inférieure comportant une pluralité d'orifices d'injection s'étendant entre la périphérie externe et la périphérie interne de chaque couronne,
- un deuxième empilement d'une pluralité de couronnes supérieures, chaque couronne supérieure comportant une pluralité d'orifices d'évacuation s'étendant entre la périphérie externe et la périphérie interne de chaque couronne,
- une première paroi non poreuse de forme et de dimensions identiques à celles des préformes poreuses à densifier disposée sur le plateau support à l'intérieur des couronnes inférieures du premier empilement, ladite première paroi non poreuse s'étendant entre le plateau support et la couronne supérieure située à la base du deuxième empilement,
- une deuxième paroi non poreuse de forme et de dimensions identiques à celles des préformes poreuses à densifier, ladite deuxième paroi non poreuse s'étendant entre la couronne inférieure située au sommet du premier empilement et la couronne supérieure située au sommet du deuxième empilement.

Le dispositif de chargement de l'invention permet, par conséquent, de réaliser la densification de préformes tronconiques poreuses, et ce en augmentant la qualité et l'homogénéité des pièces obtenues ainsi que le volume de chargement de la chambre de réaction.

En effet, chaque couronne inférieure du premier empilement forme un support pour la base d'une préforme poreuse tronconique à densifier. En montant ainsi les préformes poreuses dans le dispositif de chargement, il est possible d'emboîter de façon optimale les préformes tout en ménageant des espaces de circulation pour le gaz réactif de chaque côté des préformes.

En outre, ces espaces étant chacun alimentés en gaz réactif de façon indépendante par une couronne inférieure, il est possible de délivrer une quantité de gaz réactif équivalente dans chacun de ces espaces et d'obtenir une densification uniforme des préformes.

Le dispositif de chargement de l'invention permet également de charger l'ensemble des préformes à densifier dans une chambre de réaction d'un four ou d'une installation de densification en une seule opération. Le temps d'immobilisation de l'installation est ainsi considérablement diminué et la productivité de cette dernière significativement améliorée.

Selon un premier aspect du dispositif de chargement de l'invention, celui-ci comprend en outre un mât disposé au centre du plateau support et supportant le deuxième empilement de couronnes supérieures.

Selon un deuxième aspect du dispositif de chargement de l'invention, celui-ci comprend en outre un couvercle disposé sur la couronne supérieure située au sommet du deuxième empilement.

Selon un troisième aspect du dispositif de chargement de l'invention, chaque couronne inférieure comporte une portion annulaire destinée à supporter une préforme poreuse à densifier.

Selon un quatrième aspect du dispositif de chargement de l'invention, chaque couronne inférieure présente une hauteur déterminée en fonction de l'espace à ménager entre deux préformes poreuses adjacentes. On peut ainsi ajuster les dimensions du volume de circulation de gaz de chaque côté des préformes.

Selon un cinquième aspect du dispositif de chargement de l'invention, les couronnes inférieures et les couronnes supérieures sont séparées les unes des autres par un joint en graphite afin de permettre un démontage aisé du dispositif de chargement après chaque cycle de densification. Le joint est de préférence un joint en graphite expansé comme les matériaux commercialisés sous les marques Sigraflex® ou Papyex®.

La présente invention a également pour objet une installation de densification par infiltration chimique en phase vapeur de préformes poreuses de forme tronconique, comportant une chambre de réaction, une conduite d'admission de gaz réactif située à une première extrémité de la chambre et débouchant dans une zone de préchauffage, et une conduite d'évacuation située au voisinage d'une seconde extrémité de la chambre opposée à la première,

caractérisée en ce que la chambre comprend une pluralité de préformes poreuses de forme tronconique montées dans le dispositif de chargement selon l'invention, l'extrémité inférieure de chaque préforme reposant sur une couronne inférieure du premier empilement de manière à emboîter les préformes poreuses les unes sur les autres en ménageant un espace entre chaque préforme, ledit espace formant un volume pour la circulation du gaz réactif de chaque côté des préformes, chaque volume étant alimenté en gaz réactif par les orifices d'une couronne inférieure du premier empilement.

Comme indiqué ci-dessus, en outre de permettre un chargement optimal de préformes poreuses de forme tronconique et de grandes dimensions dans une chambre de réaction d'une installation de densification, l'installation de densification combinée au dispositif de chargement de l'invention permet d'améliorer l'infiltration des préformes à la fois en termes de degré de densification et d'homogénéité de densification.

En effet, la circulation forcée des flux de gaz réactif dans les espaces ménagés de chaque côté des préformes poreuses permet de provoquer une convection forcée du gaz réactifs qui favorise et accélère l'infiltration des préformes.

Par ailleurs, les couronnes inférieures permettent d'introduire un débit équivalent de gaz réactif dans chaque volume ménagé de chaque côté des préformes poreuses tout en minimisant la perte de charge entre ces volumes et le volume présent à l'extérieur des préformes poreuses. Par conséquent, le débit de gaz est similaire dans chacun des volumes. En outre le gaz introduit dans chacun des volumes présente un état de maturation (concentration en éléments réactifs) et une cinématique d'appauvrissement (diminution de la concentration en éléments réactifs) entre la base et le sommet des préformes équivalents, ce qui permet d'obtenir une densification homogène de toutes les préformes poreuses.

La circulation forcée des flux de gaz réactif dans les volumes présents autour des préformes poreuses permet d'obtenir des vitesses de passage de gaz réactif autour des préformes poreuses nettement supérieures à celles observées avec les procédés de l'art antérieur comme ceux notamment décrits dans les documents US 7 182 980 et US 5 904 957. Cela permet de minimiser les variations de concentration de gaz réactif entre la base et le sommet des préformes et, par conséquent, de réduire les gradients de densification sur la hauteur des préformes.

Selon un premier aspect de l'installation de l'invention, celle-ci comprend en outre un anneau d'étanchéité s'étendant entre le plateau support du dispositif de chargement et la paroi interne de la chambre de réaction. Un tel anneau d'étanchéité permet de favoriser le passage des flux de gaz réactif dans les orifices des couronnes inférieures.

Selon un deuxième aspect de l'installation de l'invention, l'anneau d'étanchéité comprend un porte-joint annulaire disposé sur le plateau support et un joint en graphite s'étendant à partir de la périphérie externe dudit porte-joint annulaire, ledit joint étant en contact avec la paroi interne de la chambre de réaction.

Selon un troisième aspect de l'installation de l'invention, les dimensions des orifices d'injection des couronnes inférieures sont définis en fonction du débit de gaz réactif destiné à alimenter chaque volume de circulation de gaz réactif.

Selon un quatrième aspect de l'installation de l'invention, les préformes poreuses sont des préformes de pièces d'arrière-corps de moteur aéronautique.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels:
- les figures 1A à 1N sont des vues schématiques montrant le montage et le chargement d'un dispositif de chargement conformément à un mode de réalisation de l'invention ;
- la figure 2 est une vue en coupe d'une installation de densification par infiltration chimique en phase vapeur ;
- les figures 3A à 3C sont des vues en coupe montrant la mise en place d'un dispositif de chargement et d'un anneau d'étanchéité selon l'invention dans l'installation de la figure 2 ;
- la figure 4 est une vue schématique en perspective éclatée d'un anneau d'étanchéité conformément à un mode de réalisation de l'invention;
- la figure 5 est une vue de détail en perspective de l'anneau d'étanchéité représenté sur la figure 3C ;
- les figures 6 et 7 sont des vues en coupe partielle montrant le trajet des flux de gaz réactifs lors de la densification de préformes poreuses durant le fonctionnement l'installation de la figure 3C.

### Description détaillée de mode de réalisation

La présente invention s'applique à la densification de préformes poreuses ayant une forme empilable telle qu'une forme tronconique mais aussi des formes qui ne sont pas de révolution telles que des formes pyramidales ou autres.

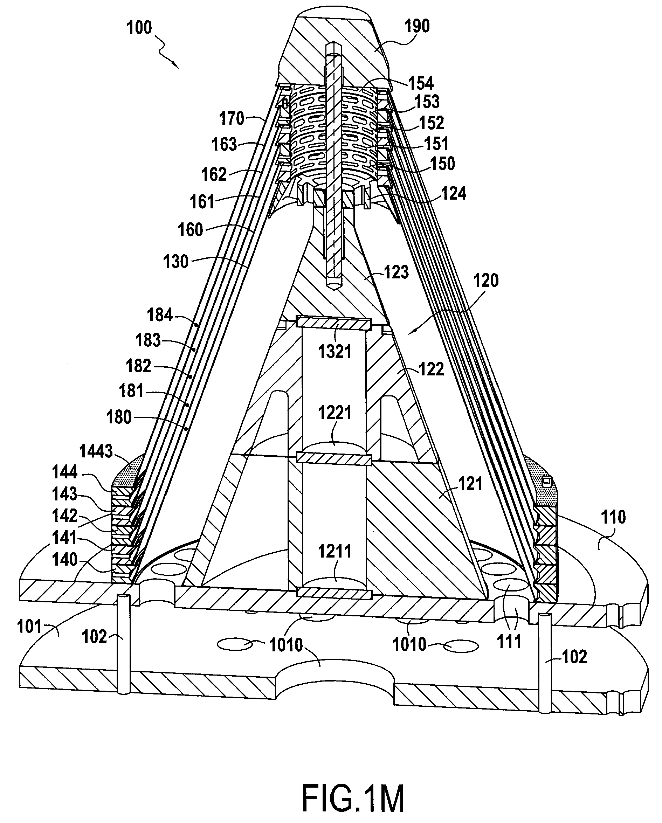

La figure 1M représente un dispositif ou outillage de chargement 100 qui, une fois chargée de préformes poreuses 160 à 163 à densifier, est destiné à être introduit dans une chambre de réaction d'une installation industrielle d'infiltration chimique en phase vapeur. Dans l'exemple décrit ici, le dispositif de chargement est destiné à recevoir des préformes fibreuses de forme coniques pouvant constituer notamment des divergents de moteur-fusée ou tout ou partie de pièces d'arrière-corps de moteur aéronautique tels que des cônes d'échappement (encore appelés « plugs »).

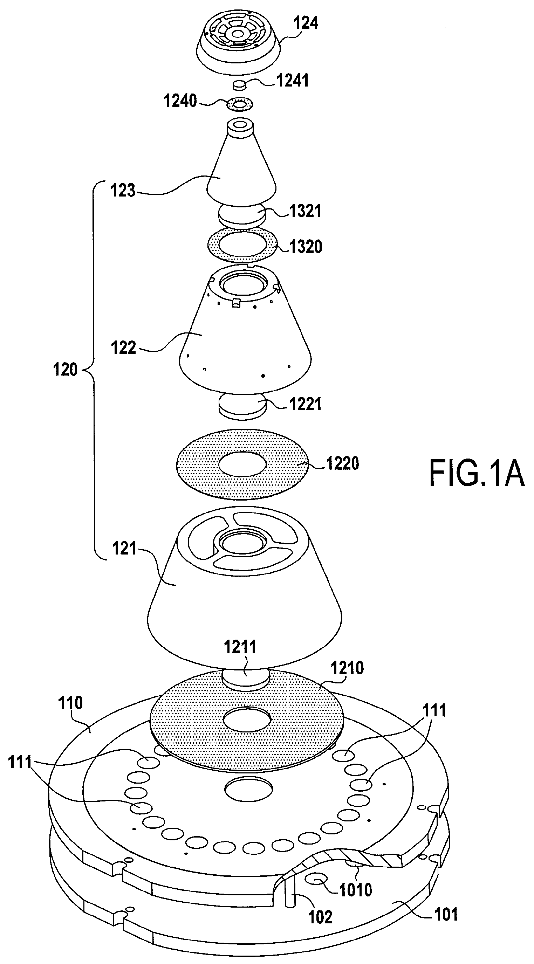

En référence aux figures 1A à 1N, on décrit à la fois le montage d'un dispositif de chargement et le chargement des préformes poreuses dans celui-ci conformément à une mode de réalisation de l'invention.

Comme illustré sur la figure 1A, le montage du dispositif de chargement est réalisé à partir d'un plateau support circulaire 110 comportant une pluralité d'orifices d'évacuation 111 disposés de façon annulaire sur le plateau support 110. Dans l'exemple décrit ici, le plateau support 110 est en outre monté sur un socle 101 via des entretoises 102, le socle 101 comportant des orifices d'évacuation 1010.

Un mât 120, ici de forme conique, est placé sur le plateau support 110. Dans l'exemple décrit ici, le mât 120 est constitué de trois éléments tronconiques empilés les uns sur les autres, à savoir une base 121 posée sur la partie centrale du plateau support 110 avec interposition d'un joint en graphite 1210 et d'un pion de centrage 1211, une portion intermédiaire 122 placée sur la base 121 avec interposition d'un joint en graphite 1220 et d'un pion de centrage 1221 et un sommet 123 placé sur la portion intermédiaire 122 avec interposition d'un joint en graphite 1230 et d'un pion de centrage 1231. Le sommet 123, préalablement recouvert d'un joint en graphite 1240 et d'un pion de centrage 1241, est coiffé par une couronne de centrage 124 permettant de positionner une paroi interne non poreuse comme décrit ci-après.

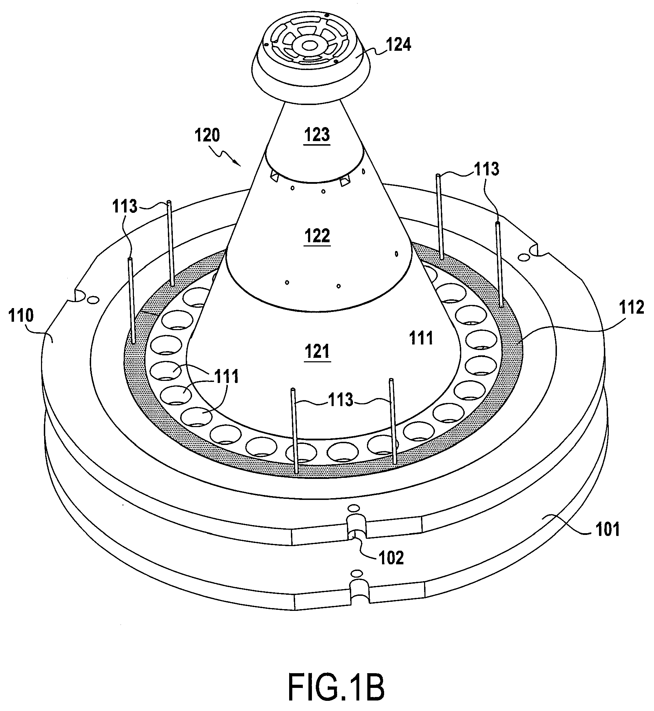

Un joint annulaire en graphite 112 et des tiges filetées 113 sont positionnées sur le plateau support 110 autour des orifices d'évacuation 111 (figure 1B).

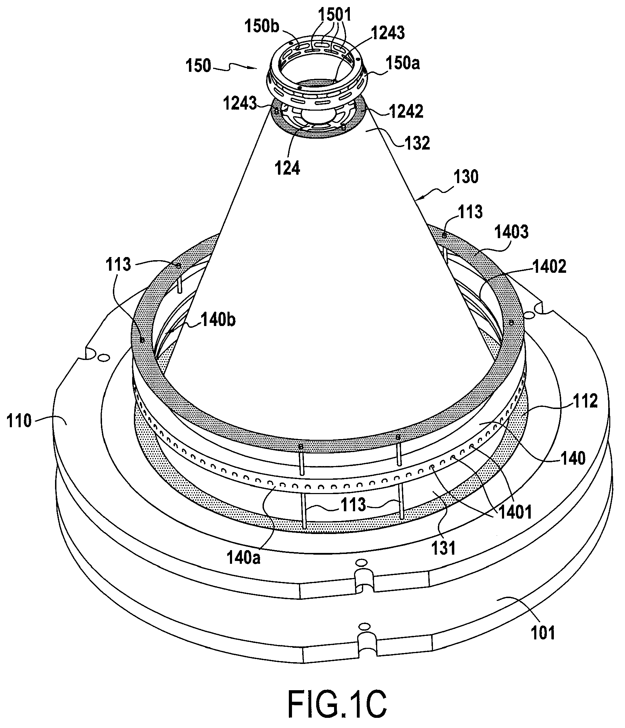

Une paroi interne non poreuse 130 est alors positionnée sur le plateau support 110 comme représentée sur la figure 1C. Plus précisément, la base 131 de la paroi interne non poreuse 130 repose sur le plateau support 110 via le joint 112 tandis que le sommet 132 de la paroi 130 coopère avec la couronne de centrage 124 présente au sommet 123 du mât 120. La paroi 130 présente une forme et des dimensions identiques à celles des préformes poreuses qui vont être empilées sur le dispositif comme décrit ci-après.

Dans le cas où la paroi non poreuse 130 est suffisamment résistante mécaniquement pour supporter un empilement de couronnes supérieures et un éventuel couvercle comme décrits ci-après, le dispositif de chargement peut être dépourvu de mât central comme le mât 120 décrit ci-dessus. Dans ce cas, l'utilisation d'une couronne de centrage comme la couronne 124 n'est plus nécessaire.

La figure 1C montre en outre la mise en place d'une première couronne inférieure 140 sur le plateau support 110 au niveau du joint annulaire en graphite 112, la couronne 140 entourant la base 131 de la paroi non poreuse. La couronne inférieure 140 comporte une pluralité d'orifices 1401 s'étendant entre la périphérie externe 140a et la périphérie interne 140b de la couronne 140. La couronne inférieure 140 comporte en outre sur sa périphérie interne une portion annulaire 1402 destinée à supporter la base d'une préforme poreuse. Un joint annulaire en graphite 1403 est disposé sur la partie supérieure de la couronne 140.

Une première couronne supérieure 150 est disposée sur la couronne de centrage 124 au sommet 123 du mât 120 avec interposition d'un joint en graphite 1242 et de pions de centrage 1243. La couronne supérieure 150 comporte une pluralité d'orifices 1501 s'étendant entre la périphérie externe 150a et la périphérie interne 150b.

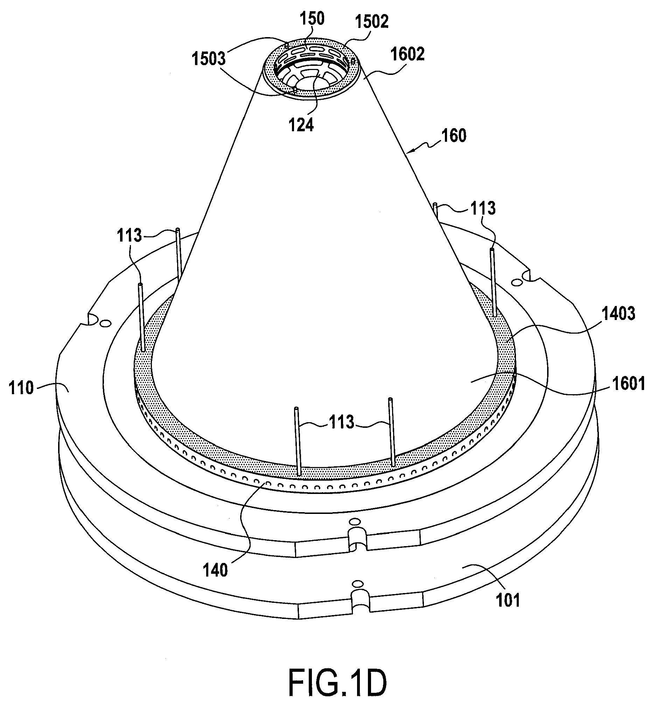

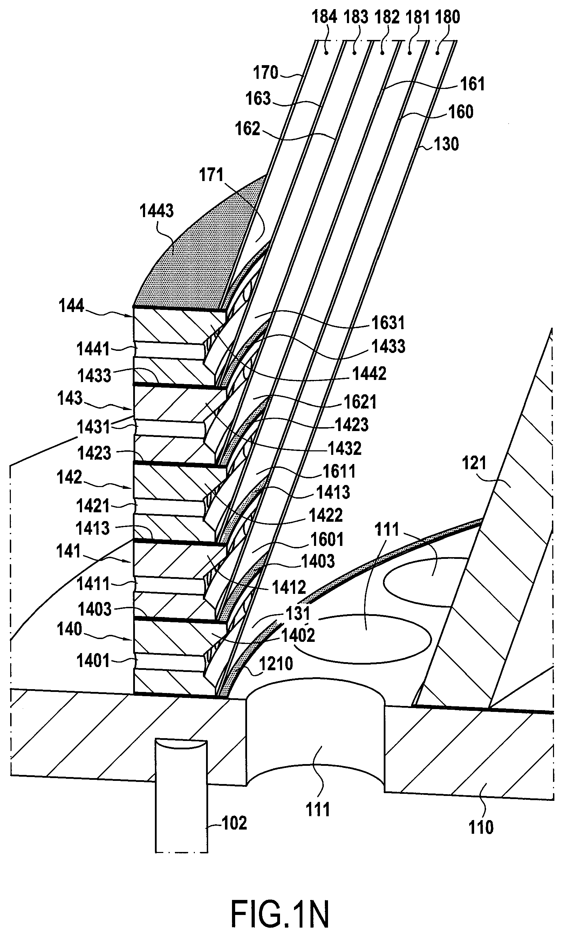

La figure 1D montre le positionnement d'une première préforme poreuse 160 dont la base 1601 repose sur la portion annulaire 1402 de la première couronne inférieure 140 recouverte du joint 1403 (figure 1N), le sommet 1602 de la première préforme 160 coopérant avec la première couronne supérieure 150, un joint annulaire en graphite 1502 et des pions de centrage 1503 étant positionnés sur la partie supérieure de la couronne 150 et sur le sommet 1602 de la première préforme poreuse 160.

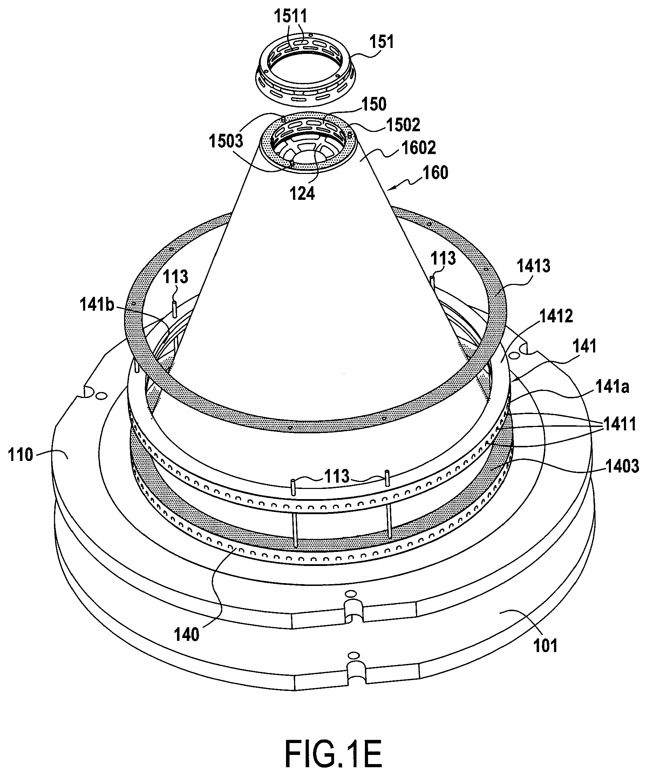

Sur la figure 1E, une deuxième couronne inférieure 141 identique à la première couronne inférieure 140, c'est-à-dire présentant des dimensions similaires et comportant une pluralité d'orifice 1411 et une portion annulaire 1412 destinée à supporter la base d'une deuxième préforme poreuse, est mise en place sur la première couronne inférieure 140 avec interposition du joint annulaire en graphite 1403. Un autre joint annulaire en graphite 1413 est disposé sur la partie supérieure de la couronne 141. Une deuxième couronne supérieure 151 également identique à la première couronne supérieure 150, en ce qu'elle présente les mêmes dimensions et comporte aussi une pluralité d'orifices 1511, est positionnée sur la première couronne supérieure 150 avec interposition du joint annulaire en graphite 1502.

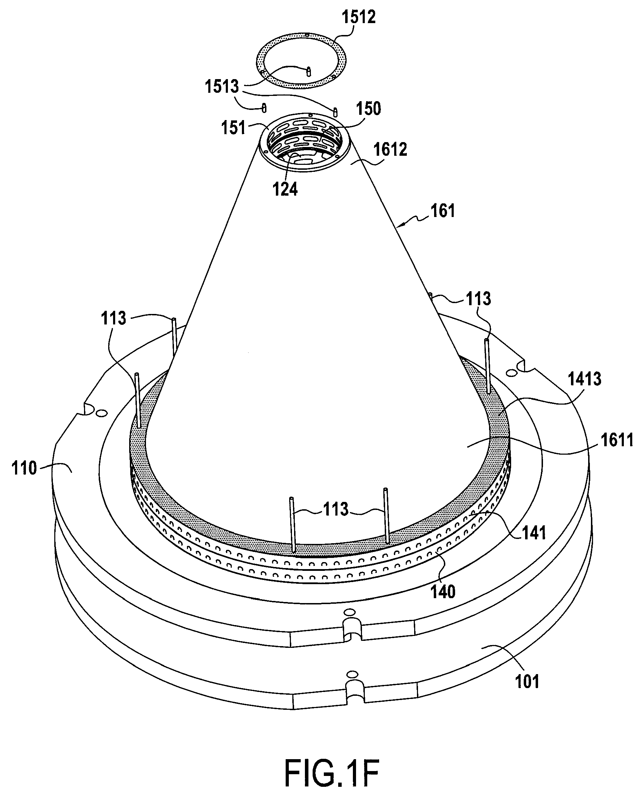

Sur la figure 1F, une deuxième préforme poreuse 161 est ensuite emboîtée sur la première préforme 160. La base 1611 de la deuxième préforme poreuse 161 repose sur la portion annulaire 1412 de la deuxième couronne inférieure 141 recouverte du joint 1413 (figure 1N) tandis que le sommet 1612 de la deuxième préforme 161 coopère avec la deuxième couronne supérieure 151. Un joint annulaire en graphite 1512 et des pions de centrage 1513 étant positionnés sur la partie supérieure de la couronne 151.

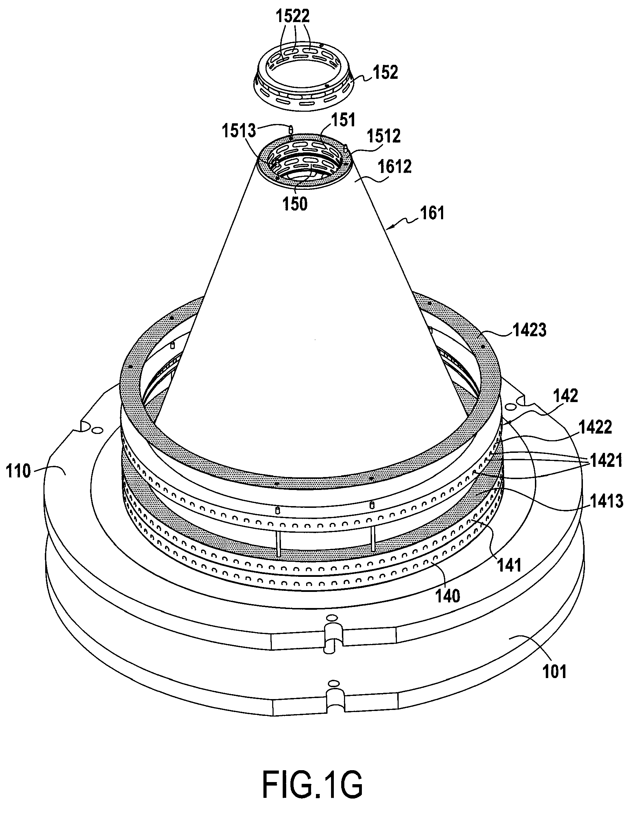

Sur la figure 1G, une troisième couronne inférieure 142 identique aux couronnes inférieures 140 et 141, c'est-à-dire présentant des dimensions similaires et comportant une pluralité d'orifice 1421 et une portion annulaire 1422 destinée à supporter la base d'une troisième préforme poreuse, est mise en place sur la deuxième couronne inférieure 141 avec interposition du joint annulaire en graphite 1413. Un autre joint annulaire en graphite 1423 est disposé sur la partie supérieure de la couronne 142. Une troisième couronne supérieure 152 également identique aux couronnes supérieures 150 et 151, en ce qu'elle présente les mêmes dimensions et comporte aussi une pluralité d'orifices 1521, est positionnée sur la deuxième couronne supérieure 151 avec interposition du joint annulaire en graphite 1512.

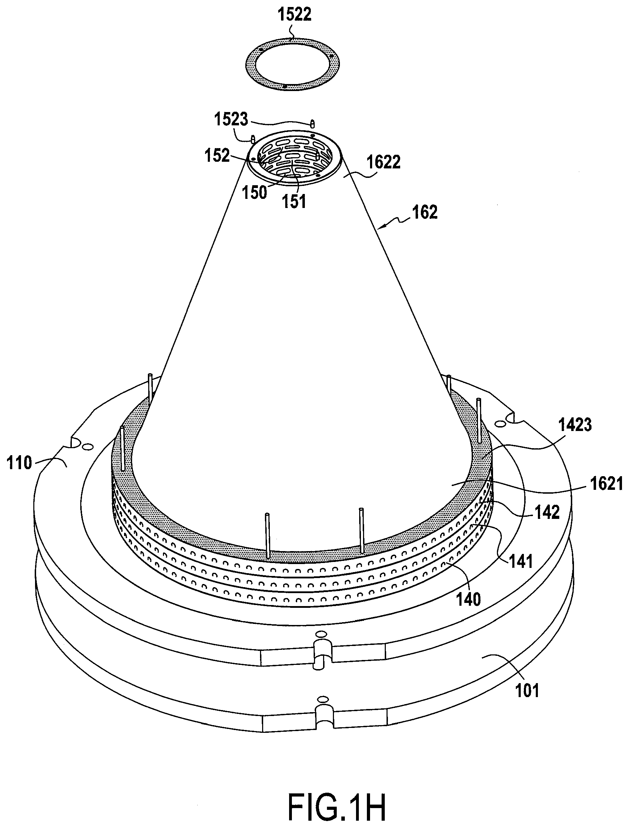

Sur la figure 1H, une troisième préforme poreuse 162 est ensuite emboîtée sur la deuxième préforme 161. La base 1621 de la troisième préforme poreuse 162 repose sur la portion annulaire 1422 de la troisième couronne inférieure 142 recouverte du joint 1423 (figure 1N) tandis que le sommet 1622 de la troisième préforme 162 coopère avec la troisième couronne supérieure 152. Un joint annulaire en graphite 1522 et des pions de centrage 1523 étant positionnés sur la partie supérieure de la couronne 152.

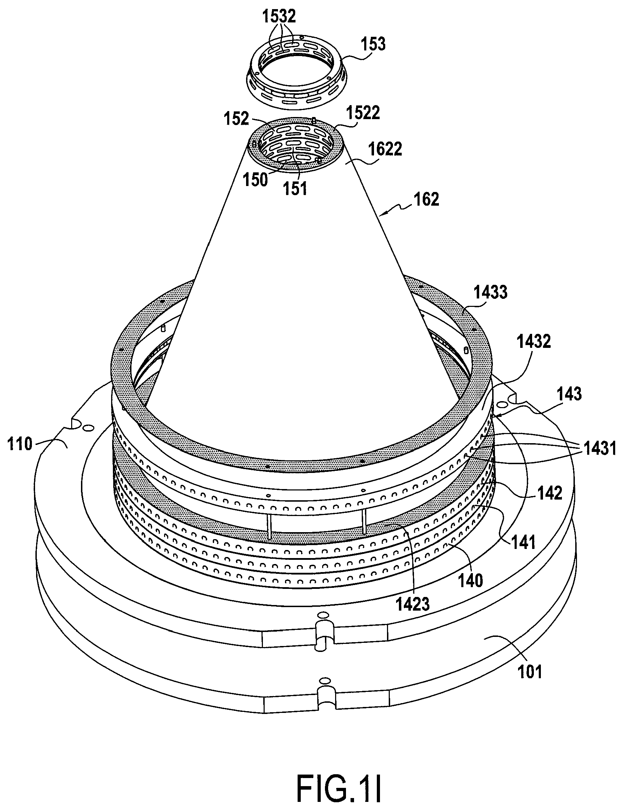

Sur la figure 1I, une quatrième couronne inférieure 143 identique aux couronnes inférieures 140 à 142, c'est-à-dire présentant des dimensions similaires et comportant une pluralité d'orifice 1431 et une portion annulaire 1432 destinée à supporter la base d'une quatrième préforme poreuse, est mise en place sur la troisième couronne inférieure 142 avec interposition du joint annulaire en graphite 1423. Un autre joint annulaire en graphite 1433 est disposé sur la partie supérieure de la couronne 143. Une quatrième couronne supérieure 153 également identique aux couronnes supérieures 150 à 152, en ce qu'elle présente les mêmes dimensions et comporte aussi une pluralité d'orifices 1531, est positionnée sur la troisième couronne supérieure 152 avec interposition du joint annulaire en graphite 1522.

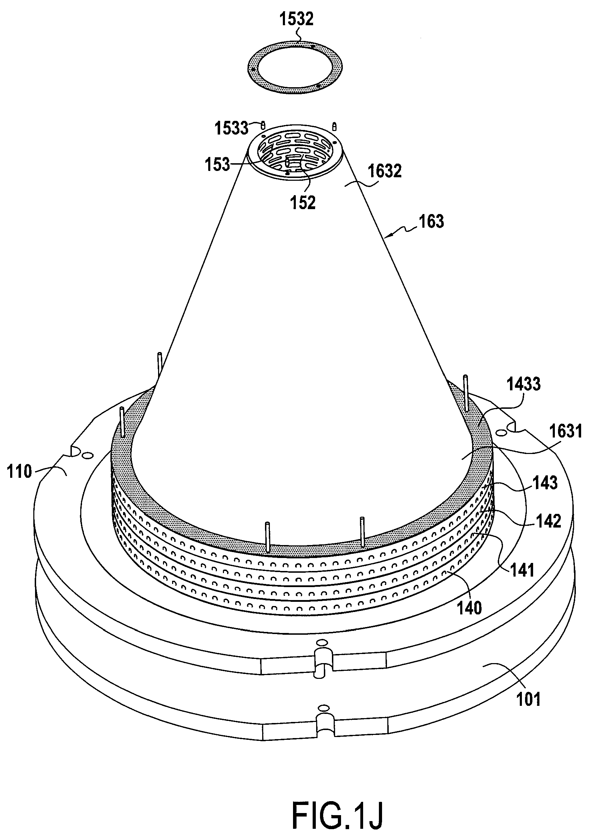

Sur la figure 1J, une quatrième préforme poreuse 163 est ensuite emboîtée sur la troisième préforme 163. La base 1631 de la quatrième préforme poreuse 163 repose sur la portion annulaire 1432 de la quatrième couronne inférieure 143 recouverte du joint 1433 (figure 1N) tandis que le sommet 1632 de la quatrième préforme 163 coopère avec la quatrième couronne supérieure 153. Un joint annulaire en graphite 1532 et des pions de centrage 1533 étant positionnés sur la partie supérieure de la couronne 153.

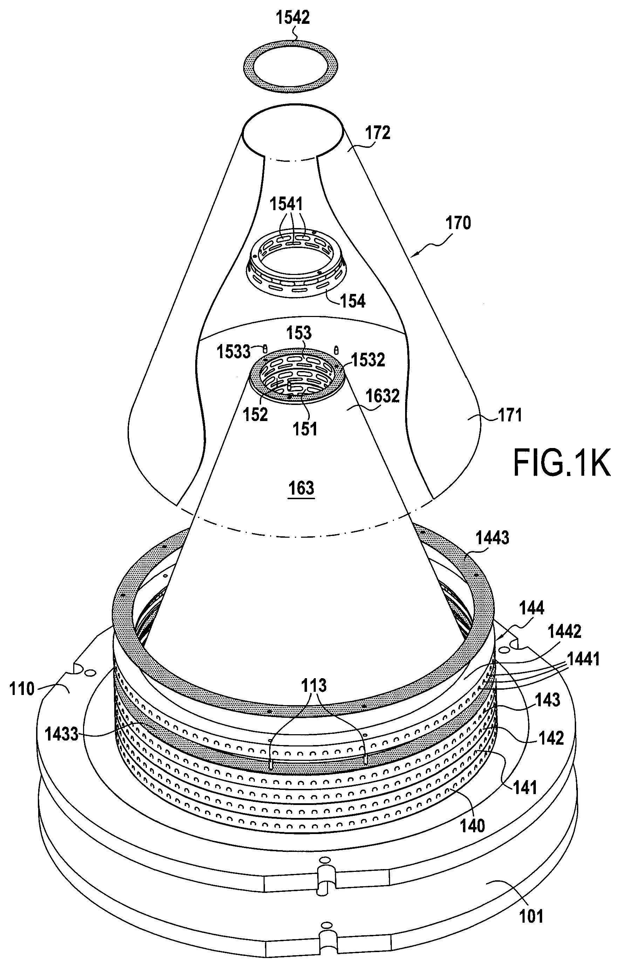

Une fois, le positionnement de la quatrième préforme fibreuse 163 sur la portion annulaire 1432 de la quatrième couronne inférieure 143 recouverte du joint 1433 (figure 1N) achevé, une cinquième couronne inférieure 144 et une cinquième couronne supérieure 154 sont placées respectivement sur les quatrièmes couronnes inférieure 144 et supérieure 154 avec interposition des joints annulaires en graphite 1433 et 1532 comme représenté sur la figure 1K. La cinquième couronne inférieure 144 présente respectivement les mêmes dimensions que les couronnes inférieures 140 à 143 et comportent comme ces dernières une pluralité d'orifices 1441 ainsi qu'une portion annulaire 1442. La cinquième couronne supérieure 154 présente les mêmes dimensions que les couronnes supérieures 150 à 153 et comportent comme ces dernières une pluralité d'orifices 1541.

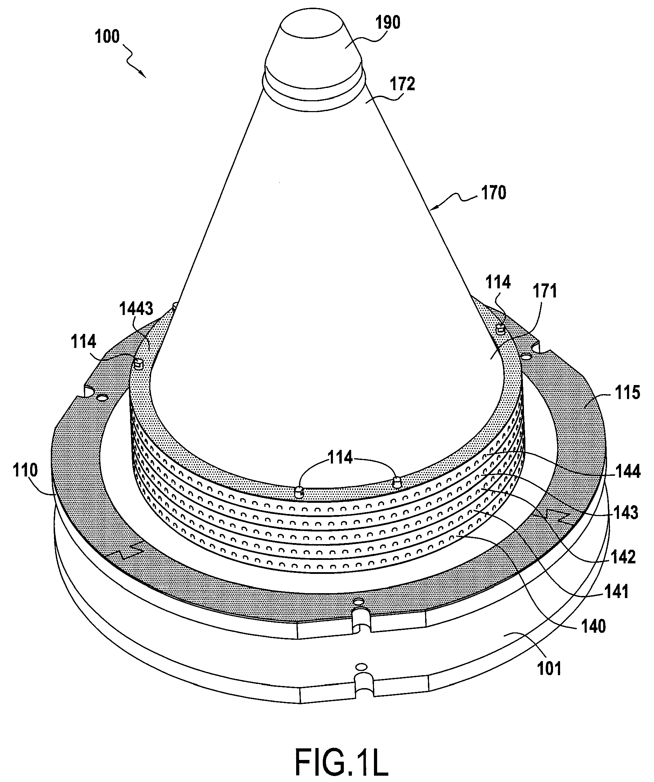

Comme illustré sur les figures 1K et 1L, l'empilement des préformes poreuses 160 à 163 est ensuite fermé par le positionnement d'une paroi externe non poreuse 170 présentant une forme et des dimensions identiques à celles des préformes poreuses. La base 171 de la paroi externe non poreuse 170 repose sur la portion annulaire 1442 de la cinquième couronne inférieure 144 recouverte du joint 1443 (figure 1N) tandis que le sommet 172 de la paroi 170 coopère avec la partie supérieure de la cinquième couronne supérieure 154. Un couvercle ou bouchon 190 est en outre fixé, via un joint en graphite 1542, sur la partie supérieure de la cinquième couronne supérieure 154 afin de fermer le sommet de l'empilement au niveau du sommet 172 de la paroi 170. Le sommet de l'empilement des couronnes supérieures peut être également fermé en utilisant, comme dernière couronne de l'empilement, une couronne fermée dans sa partie supérieure, l'utilisation d'un couvercle ou bouchon n'étant dans ce cas plus nécessaire.

L'empilement des couronnes inférieures 140 à 144 est solidarisé avec le plateau support 110 par le serrage d'écrous 114 sur les tiges filetées 113. Un joint annulaire en graphite 115 est disposé sur le plateau support à proximité de sa périphérie externe.

Comme illustré sur la figure 1M, les espaces respectivement présents entre la paroi non poreuse 130, les préformes poreuses 160, 161, 162, 163 et la paroi non poreuse 170 forment respectivement des volumes 180 à 184 s'étendant tout autour de chaque préforme poreuse et dans lesquels circulent les flux de gaz réactif destiné à densifier les préformes poreuses 160 à 163. La distance entre deux préformes fibreuses adjacentes ou entre une paroi non poreuse et la préforme adjacente est relativement faible, par exemple 10 mm, de sorte que dans chacun des volumes 180 à 184 le gaz réactif circule au plus près des préformes poreuses à densifier.

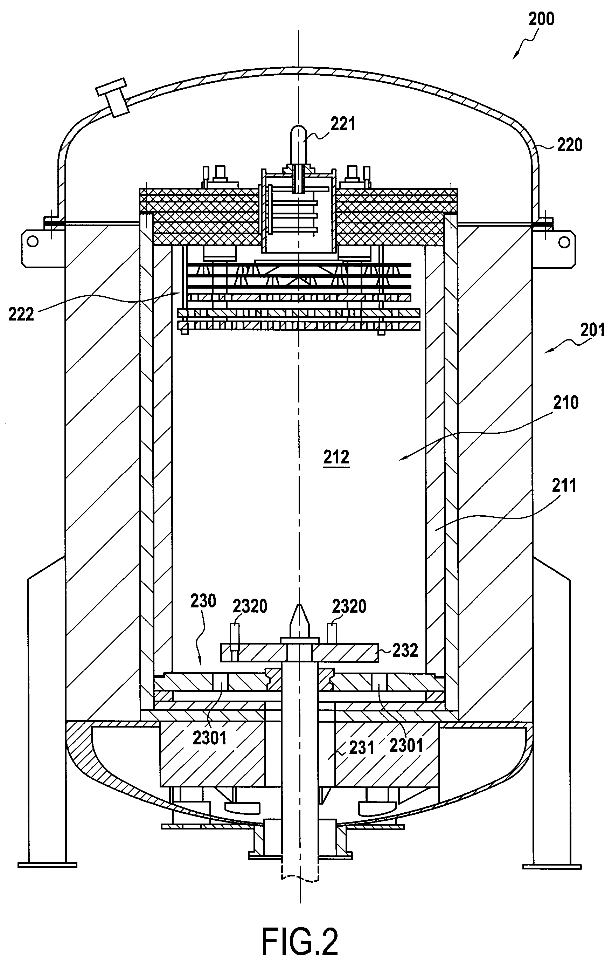

La figure 2 représente schématiquement une installation ou four d'infiltration chimique en phase vapeur 200 destiné à recevoir le dispositif de chargement 100 comprenant les préformes poreuses à densifier. De façon connue en soi, l'installation d'infiltration chimique en phase vapeur 200 comprend une enceinte cylindrique 201 délimitant une chambre de réaction 210 fermée dans sa partie supérieure par un couvercle démontable 220 muni d'une conduite d'admission de gaz 221 qui débouche dans une zone de préchauffage 222 permettant de réchauffer le gaz avant sa diffusion dans la chambre de réaction 210 contenant les préformes à densifier. Les gaz résiduels sont extraits au niveau du fond 230 de l'installation par une conduite d'évacuation 231 qui est reliée à des moyens d'aspiration (non représentés). Le fond 230 comporte un support 232 traversé par la conduite d'évacuation 231 et sur lequel le dispositif de chargement 100 est destiné à être déposé via des entretoises 2320.

Le chauffage dans la zone préchauffage ainsi qu'à l'intérieur de la chambre de réaction 210 est produit par un suscepteur en graphite 211 formant un induit couplé électromagnétiquement avec un inducteur (non représenté). L'espace présent dans la chambre de réaction 210 entre la zone de préchauffage 222 et le support 232 correspond au volume de chargement utile 212 de l'installation d'infiltration 200, c'est-à-dire le volume disponible pour charger des préformes fibreuses à densifier.

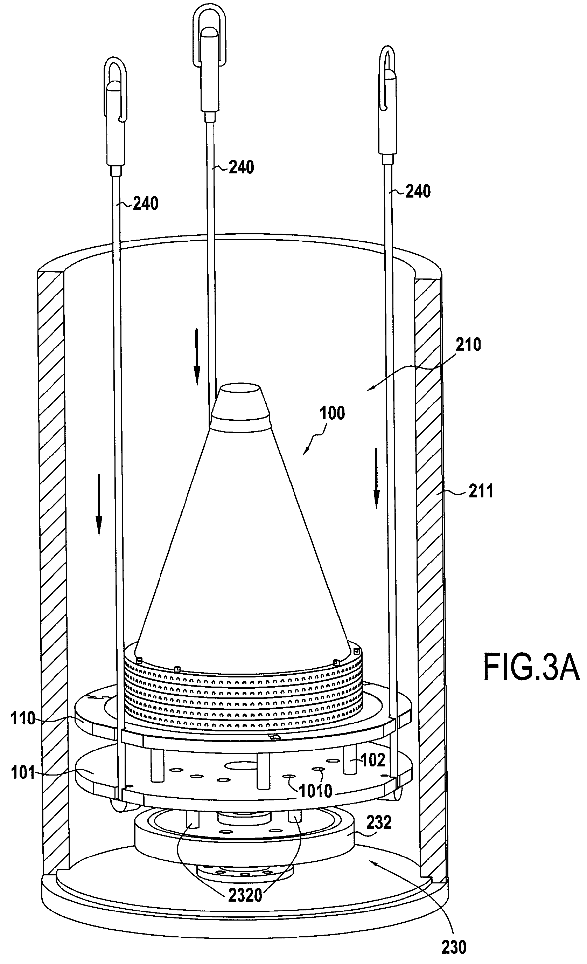

On décrit maintenant la mise en place du dispositif de chargement 100 comprenant les préformes poreuses 160 à 163 à densifier dans l'installation d'infiltration chimique en phase vapeur 200. Comme illustré sur la figure 3A, le couvercle 220 de l'installation 200 est démonté afin de permettre l'introduction du dispositif de chargement 100 dans la chambre de réaction 210, le dispositif de chargement 100 étant descendu dans la chambre 210, par exemple au moyen de tirants de manutention 240, jusqu'à ce que le socle 101 du dispositif de chargement repose sur le support 232 via les entretoises 2320.

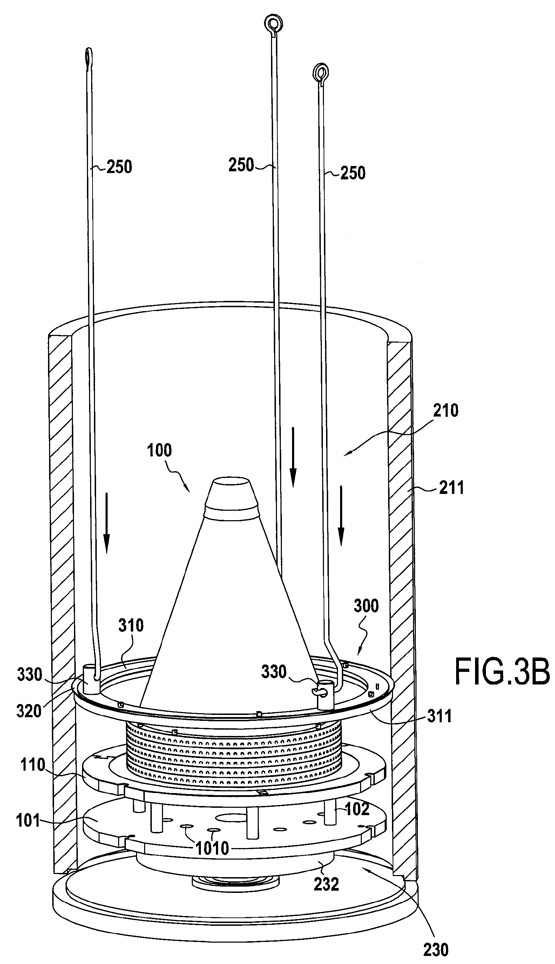

Conformément à l'invention, un anneau d'étanchéité 300 est en outre déposé sur le plateau support 110 du dispositif de chargement 100, par exemple au moyen de tirants de manutention 250 coopérant avec des goujons 330 fixés sur l'anneau d'étanchéité 300 (figure 3B).

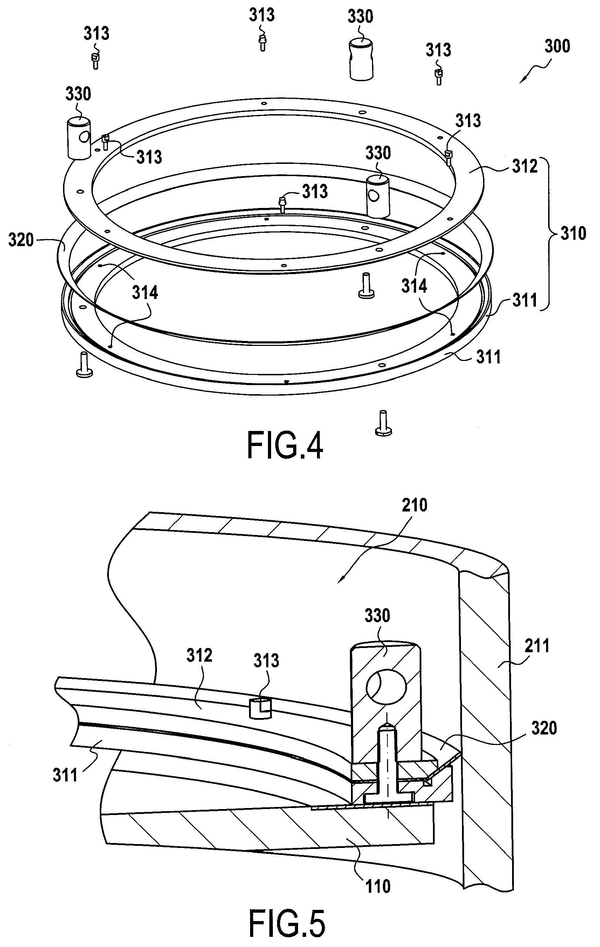

Comme illustré sur la figure 4, l'anneau d'étanchéité comprend un porte-joint annulaire 310 formé d'une partie inférieure 311 et d'une partie supérieure 312 et un joint annulaire en graphite 320 pincé entre les parties 311 et 312 du porte-joint 310 par serrage de vis 313 dans des portions filetées 314 ménagées dans la partie inférieure 311 du porte-joint 310.

Comme illustré sur la figure 5, le joint en graphite 320 s'étend à partir de la périphérie externe du porte-joint 310 sur distance déterminée de manière à venir en contact avec la paroi interne du suscepteur 211 formant la paroi interne de la chambre de réaction 210.

Comme décrit ci-après, l'anneau d'étanchéité 300 permet de forcer les flux gazeux introduits dans la chambre de réaction à pénétrer dans les orifices des couronnes inférieures et à circuler dans les espaces de circulation de gaz délimité entre les préformes poreuses ou entre une paroi non poreuse et une préforme poreuse.

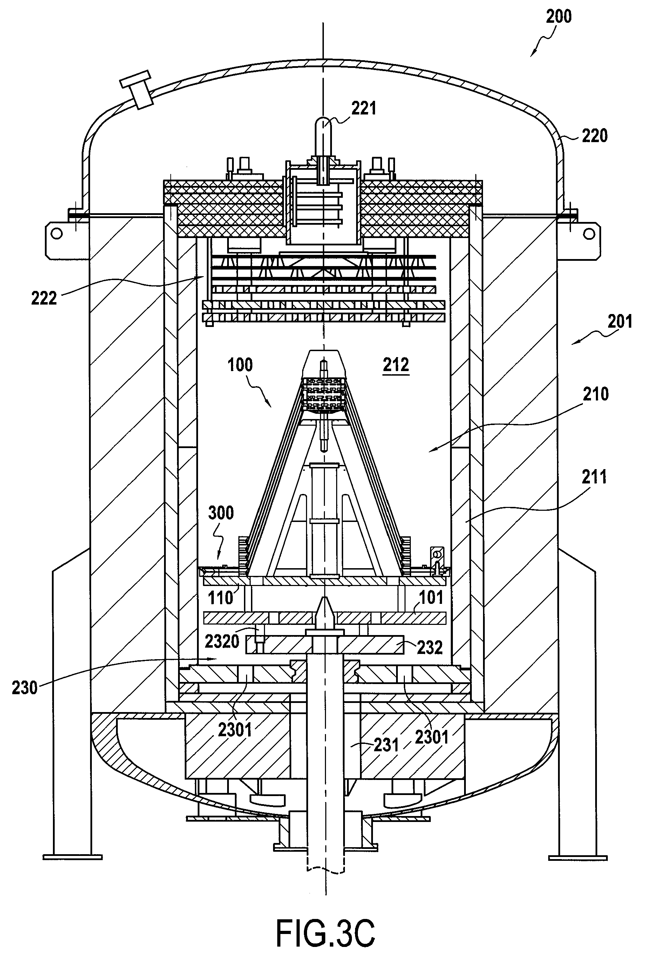

Une fois le dispositif de chargement 100 et l'anneau d'étanchéité positionnés dans la chambre de réaction 210, le couvercle 220 est monté sur la partie supérieure de l'enceinte 201 (Figure 3C). L'installation d'infiltration chimique en phase vapeur est alors prête à fonctionner.

Afin d'assurer la densification des préformes, un gaz réactif contenant au moins un ou plusieurs précurseurs du matériau de la matrice à déposer est introduit dans la chambre de réaction 210. Dans le cas du carbone par exemple, on utilise des composés gazeux hydrocarbonés, typiquement du propane, du méthane ou un mélange des deux. Dans le cas d'un matériau céramique, comme du carbure de silicium (SiC) par exemple, on peut utiliser, comme bien connu en soi, du méthyltrichlorosilane (MTS) en tant que précurseur de SiC.

La densification des préformes poreuses est assurée, de façon bien connue en soi, par dépôt au sein de celle-ci du matériau de la matrice produit par décomposition du ou des précurseurs contenus dans le gaz réactif diffusant à l'intérieur de la porosité interne accessible des substrats. Les conditions de pression et de température nécessaires pour obtenir des dépôts de matrices diverses par infiltration chimique en phase vapeur sont bien connues en elles-mêmes.

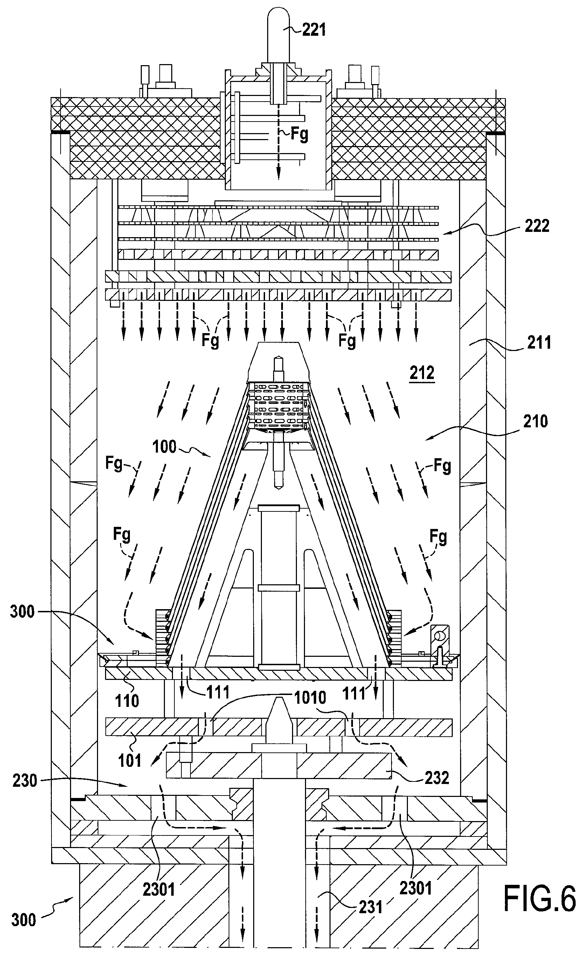

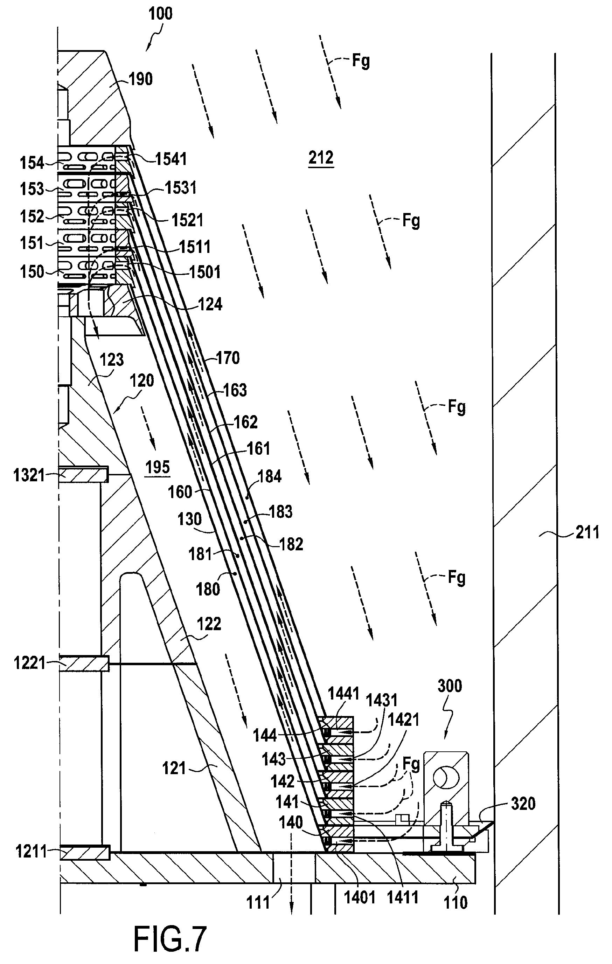

Les figures 6 et 7 montrent le trajet suivi par les flux de gaz réactif Fg introduits dans la chambre de réaction 210 par la conduite d'admission 221. Un gradient de pression est établi entre la conduite d'alimentation 221 et la conduite d'évacuation 231 afin de favoriser le passage des flux de gaz réactif dans les orifices des couronnes inférieures et leur circulation dans les volumes 180 à 184 présents de chaque côté des préformes poreuses 160 à 163. Les flux Fg traversent tout d'abord la zone de préchauffage 222 puis se répandent dans le volume présent autour du dispositif de chargement 100. Les flux de gaz Fg ne pouvant pas aller au-delà de l'anneau d'étanchéité 300, ils s'introduisent alors dans les orifices 1401, 1411, 1421, 1431 et 1441 des couronnes inférieures 140 à 144 (figure 7). Les flux de gaz circulent ensuite dans les volumes 180 à 184 présents de chaque côté des préformes poreuses 160 à 163 depuis la base de ces préformes jusqu'au sommet de celles-ci où les résidus de flux gazeux n'ayant pas réagi avec les préformes sont évacués par les orifices 1501, 1511, 1521, 1531 et 1541 des couronnes supérieures 150 à 154 puis circulent dans le volume 195 délimité entre le mât 120 et la paroi non poreuse 130 de manière à être extraits de la chambre de réaction 210 par la conduite d'évacuation 231 (figure 6).

En outre de permettre un chargement optimal de préformes poreuses de forme tronconique et de grandes dimensions dans la chambre de réaction d'une installation de densification, le dispositif de chargement de l'invention permet d'améliorer l'infiltration des préformes à la fois sur le degré de densification et sur l'homogénéité de densification.

En effet, la circulation forcée des flux de gaz réactif dans les espaces ménagés de chaque côté des préformes poreuses permet de provoquer une convection forcée du gaz réactifs qui favorise et accélère l'infiltration des préformes.

Par ailleurs, le nombre et le diamètre des orifices d'injection de gaz réactif dans les espaces ménagés de chaque côté des préformes poreuses, ici les orifices 1401, 1411, 1421, 1431 et 1441 des couronnes inférieures 140 à 144, sont identiques pour chaque couronne inférieure et pour chaque couronne supérieure de manière à introduire un débit équivalent de gaz réactif dans les volumes 180 à 184 ménagés de chaque côté des préformes poreuses. Par conséquent, le débit de gaz est similaire dans chacun des volumes 180 à 184. En outre le gaz introduit dans chacun des volumes 180 à 184 présente un état de maturation (concentration en éléments réactifs) et une cinématique d'appauvrissement (diminution de la concentration en éléments réactifs) entre la base et le sommet des préformes équivalents, ce qui permet d'obtenir une densification homogène de toutes les préformes poreuses. En outre, le diamètre des orifices d'injection de gaz réactif des couronnes inférieures sont choisis de manière à minimiser la perte de charge entre ces volumes et le volume présent à l'extérieur des préformes poreuses.

Un autre avantage du dispositif de chargement de l'invention est de pouvoir préchauffer le gaz réactif dans une zone de préchauffage standard d'une installation de densification de l'art antérieur avec des vitesses de passages et des temps de séjour dans cette zone identiques à ceux habituellement rencontrés dans les procédés de densification de l'art antérieur. Ainsi, la phase gazeuse présente une maturation similaire à celle obtenue avec dans les procédés de densification de l'art antérieur permettant d'utiliser les mêmes paramètres de densification (notamment la température, pression et concentration phase gazeuse).

Toutefois, la circulation forcée des flux de gaz réactif dans les volumes étroits 180 à 184 présents autour des préformes poreuses 160 à 163 permet d'obtenir des vitesses de passage de gaz réactif autour des préformes poreuses nettement supérieures à celles observées avec les procédés de l'art antérieur comme ceux notamment décrits dans les documents US 7 182 980 et US 5 904 957. Cela permet de minimiser les variations de concentration de gaz réactif entre la base et le sommet des préformes et, par conséquent, de réduire les gradients de densification sur la hauteur des préformes. Dans le cas d'une densification d'une pluralité de préformes poreuses de forme coniques empilées comme celles décrites ci-avant, le gaz réactif est de préférence introduit dans les volumes de circulation de gaz ménagés autour des préformes, comme les volumes 180 à 184 décrits ci-avant, au niveau de la base des préformes. De cette façon, les flux de gaz ayant la plus forte concentration en éléments réactifs sont répartis sur une plus grande surface de densification, ce qui évite un comblement trop rapide des porosités en surface des préformes empêchant une bonne infiltration à coeur de celle-ci.

Les joints en graphite décrits précédemment sont de préférence réalisé en graphite expansé comme les matériaux commercialisés sous les marques Sigraflex® ou Papyex®.

Dans l'exemple de réalisation décrit ci-avant, les préformes à densifier présentent des formes tronconiques de sorte que les couronnes inférieure et supérieure présentent des formes circulaires adaptées pour supporter et entourer respectivement la base et le sommet des préformes et parois non poreuses.

En outre, dans l'exemple décrit précédemment, le dispositif de chargement comprend quatre préformes. Toutefois, le dispositif de chargement peut comprendre un nombre plus important de préformes qui sera déterminé en fonction du volume de chargement utile de l'installation d'infiltration.

Dans le cas de préformes poreuses à densifier présentant des formes différentes, par exemple une forme pyramidale ou ovale, la géométrie des couronnes supérieure et inférieure est adaptée afin de se conformer à la forme des préformes. Par exemple, dans le cas de préformes à densifier ayant une forme de tronc de pyramide à base carrée, les couronnes supérieure et inférieure présentent une forme carrée adaptée aux dimensions respectivement de la base et du sommet des préformes.

Par ailleurs, dans l'exemple décrit ci-avant, le gaz réactif est introduit par le haut de la chambre de réaction et évacué par le bas de cette dernière. Toutefois, le gaz réactif pourrait être également introduit au niveau du fond de la chambre et évacué au niveau de la partie haute, par exemple le couvercle, de la chambre. Dans ce cas, le dispositif de chargement est par exemple disposé à l'envers dans la chambre de réaction afin de permettre l'introduction du gaz au niveau des couronnes inférieures et son évacuation au niveau des couronnes supérieures.

## Revendications

1. Dispositif de chargement (100) pour la densification, par infiltration chimique en phase vapeur en flux dirigé, dans une chambre de réaction d'un four d'infiltration, de préformes poreuses (160-163) de forme empilable, **caractérisé en ce qu'**il comprend :
- un plateau support (110),
- un premier empilement d'une pluralité de couronnes inférieures (140-144) disposé sur le plateau support (110), chaque couronne inférieure comportant une pluralité d'orifices d'injection (1401 ; 1411 ; 1421 ; 1431 ; 1441) s'étendant entre la périphérie externe et la périphérie interne de chaque couronne,
- un deuxième empilement d'une pluralité de couronnes supérieures (150-154), chaque couronne supérieure comportant une pluralité d'orifices d'évacuation (1501 ; 1511 ; 1521 ; 1531 ; 1541) s'étendant entre la périphérie externe et la périphérie interne de chaque couronne,
- une première paroi non poreuse (130) de forme et de dimensions identiques à celles des préformes poreuses à densifier (160-163) disposée sur le plateau support (110) à l'intérieur des couronnes inférieures (140-144) du premier empilement, ladite première paroi non poreuse s'étendant entre le plateau support et la couronne supérieure située à la base du deuxième empilement,
- une deuxième paroi non poreuse (170) de forme et de dimensions identiques à celles des préformes poreuses à densifier (160-163), ladite deuxième paroi non poreuse s'étendant entre la couronne inférieure (143) située au sommet du premier empilement et la couronne supérieure (154) située au sommet du deuxième empilement.

2. Dispositif selon la revendication 1, **caractérisé en ce qu'**il comprend en outre un mât (120) disposé au centre du plateau support (110) et supportant le deuxième empilement de couronnes supérieures (150-154).

3. Dispositif selon la revendication 1 ou 2, **caractérisé en ce qu'**il comprend en outre un couvercle (190) disposé sur la couronne supérieure (154) située au sommet du deuxième empilement.

4. Dispositif selon l'une quelconque des revendications 1 à 3, **caractérisé en ce que** chaque couronne inférieure (140 ; 141 ; 142 ; 143 ; 144) comporte une portion (1402 ; 1412 ; 1422 ; 1432 ; 1442) destinée à supporter une préforme poreuse à densifier.

5. Dispositif selon l'une quelconque des revendications 1 à 4, **caractérisé en ce que** chaque couronne inférieure (140 ; 141 ; 142 ; 143 ; 144) présente une hauteur déterminée en fonction de l'espace à ménager entre deux préformes poreuses adjacentes.

6. Dispositif selon l'une quelconque des revendications 1 à 5, **caractérisé en ce que** les couronnes inférieures (140-144) et les couronnes supérieures (150-154) sont séparées les unes des autres par un joint en graphite.

7. Installation de densification par infiltration chimique en phase vapeur (200) de préformes poreuses de forme tronconique (160-163), comportant une chambre de réaction (210), une conduite d'admission de gaz réactif (221) située à une première extrémité de la chambre et débouchant dans une zone de préchauffage (222), et une conduite d'évacuation (231) située au voisinage d'une seconde extrémité de la chambre opposée à la première,
**caractérisée en ce que** la chambre comprend un dispositif de chargement (100) selon l'une quelconque des revendications 1 à 6.

8. Installation selon la revendication 7, **caractérisée en ce qu'**elle comprend un anneau d'étanchéité (300) s'étendant entre le plateau support (110) du dispositif de chargement (100) et la paroi interne de la chambre de réaction (210).

9. Installation selon la revendication 8, **caractérisée en ce que** l'anneau d'étanchéité (300) comprend un porte-joint annulaire (310) disposé sur le plateau support (110) et un joint en graphite (320) s'étendant à partir de la périphérie externe dudit porte-joint annulaire, ledit joint étant en contact avec la paroi interne de la chambre de réaction (210).

10. Installation selon l'une quelconque des revendications 7 à 9, **caractérisée en ce que** les dimensions des orifices d'injection (1401 ; 1411 ; 1421 ; 1431 ; 1441) des couronnes inférieures (140-144) sont définis en fonction du débit de gaz réactif destiné à alimenter chaque volume de circulation de gaz réactif (180 ; 181 ; 182 ; 183 ; 184).

## Patentansprüche

1. Ladevorrichtung (100) für die Verdichtung von porösen Vorformlingen (160-163) mit stapelbarer Form mittels chemischer Gasphaseninfiltration in gerichtetem Strom, in einer Reaktionskammer eines Infiltrationsofens, **dadurch gekennzeichnet, dass** sie umfasst:
- eine Tragplatte (110),
- einen ersten Stapel aus einer Vielzahl von unteren Kränzen (140-144), der auf der Tragplatte (110) angeordnet ist, wobei jeder untere Kranz eine Vielzahl von Einspritzöffnungen (1401; 1411; 1421; 1431; 1441) umfasst, die sich zwischen dem Außenumfang und dem Innenumfang eines jeden Kranzes erstrecken,
- einen zweiten Stapel aus einer Vielzahl von oberen Kränzen (150-154), wobei jeder obere Kranz eine Vielzahl von Auslassöffnungen (1501; 1511; 1521; 1531; 1541) umfasst, die sich zwischen dem Außenumfang und dem Innenumfang eines jeden Kranzes erstrecken,
- eine erste nicht poröse Wand (130) mit einer Form und Abmessungen, die mit denjenigen der zu verdichtenden porösen Vorformlinge (160-163) identisch sind, welche auf der Tragplatte (110) innerhalb der unteren Kränze (140-144) des ersten Stapels angeordnet ist, wobei die erste nicht poröse Wand sich zwischen der Tragplatte und dem oberen Kranz, welcher an der Basis des zweiten Stapels gelegen ist, erstreckt,
- eine zweite nicht poröse Wand (170) mit einer Form und Abmessungen, die mit denjenigen der zu verdichtenden porösen Vorformlinge (160-163) identisch sind, wobei die zweite nicht poröse Wand sich zwischen dem unteren Kranz (143), welcher an der Spitze des ersten Stapels gelegen ist, und dem oberen Kranz (154), welcher an der Spitze des zweiten Stapels gelegen ist, erstreckt.

2. Vorrichtung nach Anspruch 1, **dadurch gekennzeichnet, dass** sie ferner einen Mast (120) umfasst, der in der Mitte der Tragplatte (110) angeordnet ist und den zweiten Stapel aus oberen Kränzen (150-154) trägt.

3. Vorrichtung nach Anspruch 1 oder 2, **dadurch gekennzeichnet, dass** sie ferner einen Deckel (190) umfasst, der auf dem oberen Kranz (154), welcher an der Spitze des zweiten Stapels gelegen ist, angeordnet ist.

4. Vorrichtung nach einem der Ansprüche 1 bis 3, **dadurch gekennzeichnet, dass** jeder untere Kranz (140; 141; 142; 143; 144) einen Abschnitt (1402; 1412; 1422; 1432; 1442) umfasst, der dazu bestimmt ist, einen zu verdichtenden porösen Vorformling zu tragen.

5. Vorrichtung nach einem der Ansprüche 1 bis 4, **dadurch gekennzeichnet, dass** jeder untere Kranz (140; 141; 142; 143; 144) eine Höhe aufweist, die in Abhängigkeit von dem zwischen zwei benachbarten porösen Vorformlingen auszusparenden Raum bestimmt ist.

6. Vorrichtung nach einem der Ansprüche 1 bis 5, **dadurch gekennzeichnet, dass** die unteren Kränze (140-144) und die oberen Kränze (150-154) durch eine Graphitdichtung voneinander getrennt sind.

7. Anlage (200) zum Verdichten von porösen, kegelstumpfförmigen Vorformlingen (160-163) durch chemische Gasphaseninfiltration, umfassend eine Reaktionskammer (210), eine Leitung zum Zuführen von reaktivem Gas (221), die an einem ersten Ende der Kammer gelegen ist und in einen Vorheizbereich (222) mündet, sowie eine Abführleitung (231), die in der Nähe eines dem ersten gegenüberliegenden zweiten Endes der Krammer gelegen ist,
**dadurch gekennzeichnet, dass** die Kammer eine Ladevorrichtung (100) nach einem der Ansprüche 1 bis 6 umfasst.

8. Anlage nach Anspruch 7, **dadurch gekennzeichnet, dass** sie einen Dichtungsring (300) umfasst, der sich zwischen der Tragplatte (110) der Ladevorrichtung (100) und der Innenwand der Reaktionskammer (210) erstreckt.

9. Anlage nach Anspruch 8, **dadurch gekennzeichnet, dass** der Dichtungsring (300) einen ringförmigen Dichtungshalter (310), der auf der Tragplatte (110) angeordnet ist, und eine Graphitdichtung (320), die sich von dem Außenumfang des ringförmigen Dichtungshalters aus erstreckt, umfasst, wobei die Dichtung mit der Innenwand der Reaktionskammer (210) in Kontakt ist.

10. Anlage nach einem der Ansprüche 7 bis 9, **dadurch gekennzeichnet, dass** die Abmessungen der Einspritzöffnungen (1401; 1411; 1421; 1431; 1441) der unteren Kränze (140-144) in Abhängigkeit von der Menge an reaktivem Gas, die dazu bestimmt ist, jedes Volumen zum Zirkulieren von reaktivem Gas (180; 181; 182; 183; 184) zu beaufschlagen, definiert sind.

## Claims

1. A loader device (100) for densifying porous preforms (160-163) of stackable shape by means of directed stream chemical vapor infiltration in a reaction chamber of an infiltration oven, the device being **characterized in that** it comprises:
· a support tray (110);
· a first stack comprising a plurality of bottom rings (140-144) arranged on the support tray (110), each bottom ring having a plurality of injection orifices (1401; 1411; 1421; 1431; 1441) extending between the outer periphery and the inner periphery of each ring;
· a second stack comprising a plurality of top rings (150-154), each top ring having a plurality of discharge orifices (1501; 1511; 1521; 1531; 1541) extending between the outer periphery and inner periphery of each ring;
· a first non-porous wall (130) of shape and dimensions identical to the shape and dimensions of the porous preforms (160-163) for densifying, said first non-porous wall being arranged on the support tray (110) inside the bottom rings (140-144) of the first stack and extending between the support tray and the top ring situated at the base of the second stack; and
· a second non-porous wall (170) of shape and dimensions identical to the shape and dimensions of the porous preforms (160-163) for densifying, said second non-porous wall extending between the bottom ring (143) situated at the top of the first stack and the top ring (154) situated at the top of the second stack.

2. A device according to claim 1, **characterized in that** it further includes a mast (120) arranged at the center of the support tray (110) and supporting the second stack comprising top rings (150-154).

3. A device according to claim 1 or claim 2, **characterized in that** it further includes a cover (190) placed on the top ring (154) situated at the top of the second stack.

4. A device according to any one of claims 1 to 3, **characterized in that** each bottom ring (140; 141; 142; 143; 144) includes a portion (1402; 1412; 1422; 1432; 1442) that is to support a porous preform for densifying.

5. A device according to any one of claims 1 to 4, **characterized in that** each bottom ring (140; 141; 142; 143; 144) presents a height that is determined as a function of the space to be arranged between two adjacent porous preforms.

6. A device according to any one of claims 1 to 5, **characterized in that** the bottom rings (140-144) and the top rings (150-154) are separated from one another by respective graphite gaskets.

7. An installation (200) for densifying porous preforms (160-163) of frustoconical shape by chemical vapor infiltration, the installation comprising a reaction chamber (210), a reagent gas admission pipe (221) situated at a first end of the chamber and leading into a preheater zone (222), and a discharge pipe (231) situated in the vicinity of a second end of the chamber opposite from the first end,
the installation being **characterized in that** the chamber contains a loader device (100) according to any one of claims 1 to 6.

8. An installation according to claim 7, **characterized in that** it includes a sealing ring (300) extending between the support tray (110) of the loader device (100) and the inner wall of the reaction chamber (210).

9. An installation according to claim 8, **characterized in that** the sealing ring (300) includes an annular gasket carrier (310) arranged on the support tray (110) and a graphite gasket (320) extending from the outer periphery of said annular gasket carrier, said gasket being in contact with the inner wall of the reaction chamber (210).

10. An installation according to any one of claims 7 to 9, **characterized in that** the dimensions of the injection orifices (1401; 1411; 1421; 1431; 1441) of the bottom rings (140-144) are defined as a function of the flow rate of reagent gas that is to feed each reagent gas flow volume (180; 181; 182; 183; 184).
